# EUROPEAN PATENT APPLICATION

(11) **EP 1 458 024 A2**
(43) Date of publication of application: **15.09.2004**
(21) Application number: 04251295.4
(22) Date of filing: 05.03.2004
(51) Int. Cl.: H01L 23/498

(54) **Interposer and semiconductor device**

(30) Priority: 06.03.2003 JP 2003060302; 11.07.2003 JP 2003195946
(71) Applicant: Shinko Electric Co. Ltd., Nagano-shi, Nagano 381-2287 (JP)
(72) Inventor: Kurihara, Takashi, Nagano-shi, Nagano 381-2287 (JP); Murayama, Kei, Nagano-shi, Nagano 381-2287 (JP)
(74) Representative: Mounteney, Simon James

(57) **Abstract**

A semiconductor device includes a semiconductor chip (12), a substrate (13) to which the semiconductor chip is connected, and an interposer (11A) provided between the semiconductor chip and the substrate so as to oppose a surface of the semiconductor chip on which a circuit is formed. The interposer connects the semiconductor chip and the substrate electrically, and is thermally connected to the semiconductor chip.

## Description

### BACKGROUND OF THE INVENTION

### 1. Field of the Invention

The present invention relates generally to semiconductor devices, and more particularly to a semiconductor device including a heat dissipating part dissipating heat generated from a semiconductor chip.

### 2. Description of the Related Art

In recent years, semiconductor devices having package structures of a BGA (ball grid array) type or an LGA (land grid array) type have been widely used to support semiconductor chips of higher densities with more pins. The BGA-type or LGA-type semiconductor devices include a substrate (for instance, a printed circuit board) on which balls or.lands serving as external connection terminals are formed. A semiconductor chip is mounted on the substrate to be electrically connected thereto.

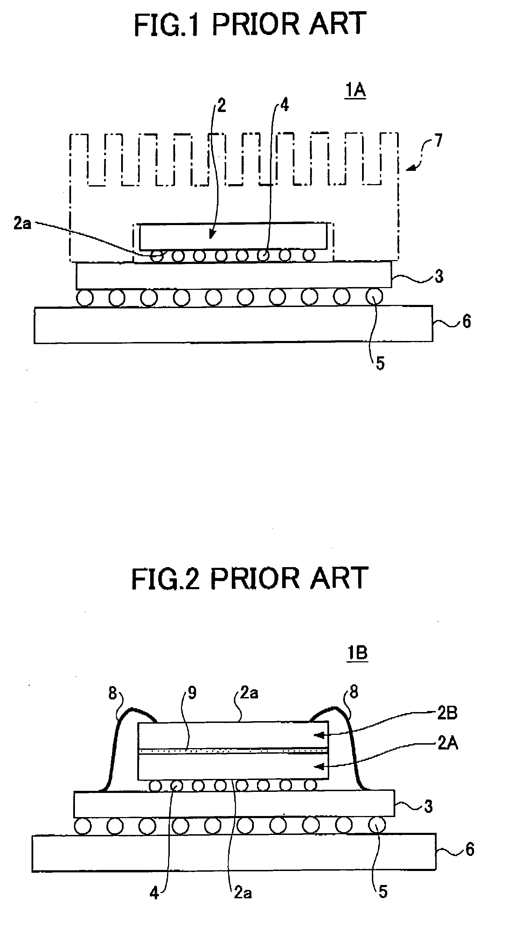

FIG. 1 is a diagram showing a conventional BGA-type semiconductor device 1A. The semiconductor device 1A is mounted on a motherboard 6 as shown in FIG. 1. The semiconductor device 1A includes a semiconductor chip 2, a substrate 3, and solder balls 5.

Common BGA-type semiconductor devices have a structure where a semiconductor chip is fixed "face up" to a substrate to be electrically connected thereto using wires. According to this configuration, however, it is difficult to support semiconductor chips having a greater number of pins.

Accordingly, the semiconductor chip 2 is fixed "face down" to the substrate 3 as shown in FIG. 1. Specifically, a large number of bumps 4 are formed on a surface (circuit surface) 2a of the semiconductor chip 2 on which surface 2a a circuit is formed. The bumps 4 are joined to the substrate 3 by flip-chip bonding so that the semiconductor chip 2 is mechanically and electrically joined to the substrate 3.

The substrate 3 is a multilayer printed circuit board having internal interconnects formed in a resin base. The internal interconnects electrically connect lands (not graphically represented) formed on the upper surface of the substrate 3 to which the bumps 4 are joined and lands (not graphically represented) formed on the lower (rear) surface of the substrate 3 to which the solder balls 5 are joined. The internal interconnects make it possible to fan out the formation positions of the solder balls 5 relative to the joining positions of the bumps 4.

FIG. 2 is a diagram showing another conventional BGA-type semiconductor device 1B. The semiconductor device 1B includes two semiconductor chips 2A and 2B stacked in layers. In FIG. 2, the same elements as those of FIG. 1 are referred to by the same numerals.

The semiconductor chips 2A and 2B have their respective rear surfaces (on the sides opposite to the circuit surfaces) fixed to each other by an adhesive agent 9. Accordingly, the semiconductor chip 2A is in a "face-down" state with respect to the substrate 3, and the semiconductor chip 2B is in a "face-up" state with respect to the substrate 3. Like in the semiconductor device 1A shown in FIG. 1, the semiconductor chip 2A is joined to the substrate 3 by flip-chip bonding using the bumps 4 so as to be mechanically and electrically connected to the substrate 3. The semiconductor chip 2B is electrically connected to the substrate 3 using wires 8.

The high-density semiconductor chips 2, 2A, and 2B generate a large amount of heat. Accordingly, the heat generated in the semiconductor chips 2, 2A, and 2B should be dissipated with efficiency to keep the semiconductor chips 2, 2A, and 2B operating normally. Therefore, a variety of conventional methods for dissipating heat generated in the semiconductor chips 2, 2A, and 2B have been proposed as disclosed in, for instance, Japanese Laid-Open Patent Application No. 11-145381.

Referring to FIG. 1, it may be considered to provide, for instance, a heat dissipating fin 7 indicated by a single-dot chain line in the semiconductor device 1A as a mechanism dissipating heat generated in the semiconductor chip 2. Since the semiconductor chip 2 is joined to the substrate 3 by flip-chip bonding, the heat dissipating fin 7 is provided on the rear surface side (the side opposite to the circuit surface 2a) of the semiconductor chip 2.

However, in the semiconductor chip 2, the circuit surface 2a on which the bumps 4 are formed generates the most heat. Accordingly, the conventional configuration of providing the heat dissipating fin 7 on the rear surface side of the semiconductor chip 2 cannot dissipate heat generated in the semiconductor chip 2 with efficiency. Further, according to the semiconductor device 1B shown in FIG. 2, it is impossible to employ such a structure of dissipating heat from the rear surface of a semiconductor chip as shown in FIG. 1, so that the semiconductor chips 2A and 2B may malfunction.

The heat generated on the circuit surface 2a of the semiconductor chip 2 is conducted to the substrate 3 via the bumps 4. As described above, the substrate 3 is a multilayer printed circuit board and includes the internal interconnects in the resin base. Accordingly, the heat generated in the semiconductor chip 2 is dissipated to some extent in the substrate 3. The substrate 3, however, is designed mainly to connect the bumps 4 and the solder balls 5 electrically, and accordingly, is not provided with much of a heat dissipating function. Therefore, the heat generated in the semiconductor chip 2 cannot be dissipated efficiently through the substrate 3 to the extent that the semiconductor chip 2 is free of problems.

### SUMMARY OF THE INVENTION

Accordingly, it is a general object of the present invention to provide a semiconductor device in which the above-described disadvantages are eliminated.

A more specific object of the present invention is to provide a semiconductor device that can ensure the dissipation of heat generated in even a flip-chip bonded semiconductor chip.

The above objects of the present invention are achieved by a semiconductor device, including: a semiconductor chip; a substrate to which the semiconductor chip is connected; and an interposer provided between the semiconductor chip and the substrate so as to oppose a surface of the semiconductor chip on which a circuit is formed, the interposer connecting the semiconductor chip and the substrate electrically, the interposer being thermally connected to the semiconductor chip.

According to the above-described semiconductor device, an interposer is provided to oppose the circuit surface of a semiconductor chip, and the interposer is thermally connected to the semiconductor chip. Accordingly, the circuit surface, which particularly generates the most heat in the semiconductor chip, and the interposer can be arranged close to each other. Therefore, heat generated in the semiconductor chip can be conducted to and dissipated by the interposer with efficiency, so that the semiconductor chip can be cooled with efficiency. Since the interposer also has the function of electrically connecting the semiconductor chip and a substrate, providing the interposer between the semiconductor chip and the substrate causes no problem in the electrical connection between the semiconductor chip and the substrate.

### BRIEF DESCRIPTION OF THE DRAWINGS

Other objects, features and advantages of the present invention will become more apparent from the following detailed description when read in conjunction with the accompanying drawings, in which:
FIG. 1 is a diagram showing a conventional BGA-type semiconductor device;
FIG. 2 is a diagram showing another conventional BGA-type semiconductor device;
FIG. 3 is a diagram showing a semiconductor device according to a first embodiment of the present invention;
FIG. 4 is a diagram showing a semiconductor device according to a second embodiment of the present invention;
FIG. 5 is a diagram showing a semiconductor device according to a third embodiment of the present invention;
FIG. 6 is a diagram showing a semiconductor device according to a fourth embodiment of the present invention;
FIG. 7 is an enlarged view of an interposer provided in the semiconductor device according to the fourth embodiment of the present invention;
FIG. 8 is a diagram showing a semiconductor device according to a fifth embodiment of the present invention;
FIG. 9 is a diagram showing a semiconductor device according to a sixth embodiment of the present invention; and
FIGS. 10A through 10D are diagrams showing a method of forming an interposer provided in the semiconductor device according to the sixth embodiment of the present invention.

### DETAILED DESCRIPTION OF THE PREFERRED EMBODIMENTS

A description is given below, with reference to the accompanying drawings, of embodiments of the present invention.

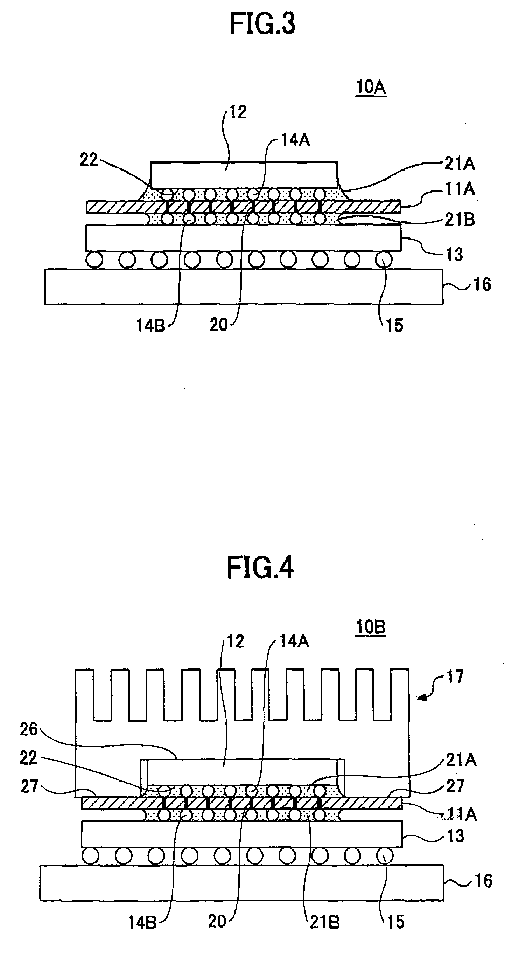

FIG. 3 is a diagram showing a semiconductor device 10A according to a first embodiment of the present invention. The semiconductor device 10A includes a semiconductor chip 12, a substrate 13, solder balls 15, and an interposer 11A. For instance, the semiconductor device 10A is mounted on a motherboard 16 through the solder balls 15 provided to the substrate 13 as shown in FIG. 3.

The semiconductor chip 12 has a plurality of first bumps 14A formed on a circuit surface 22 thereof on which a circuit is formed. The semiconductor chip 12 is joined to the interposer 11A by flip-chip bonding.

The substrate 13 is a multilayer printed circuit board including internal interconnects in a resin base. The substrate 13 has the same structure as the conventional substrate 3 shown in FIGS. 1 and 2.

First lands (to which below-described second bumps 14B are joined) are formed on the upper surface of the substrate 13. Second lands to which the solder balls 15 are joined are formed on the lower surface of the substrate 13. The first and second lands are connected by the internal interconnects provided in the substrate 13. The internal interconnects make it possible to fan out the formation positions of the second lands relative to the formation positions of the first lands.

The substrate 13 is not provided with a sufficient heat dissipating function. Accordingly, heat generated in the semiconductor chip 12 cannot be dissipated sufficiently by using the substrate 13 as a heat dissipating board.

Next, a description is given of the interposer 11A. The interposer 11A is interposed between the semiconductor chip 12 and the substrate 13 so as to oppose the circuit surface 22 of the semiconductor chip 12. The interposer 11A is made of ceramic including aluminum nitride according to this embodiment. The interposer 11A is configured to have a large area relative to the semiconductor chip 12.

The interposer 11A has vias 20 formed at positions to which the first and second bumps 14A and 14B are joined. The vias 20 are small holes penetrating vertically through the interposer 11A to which conductive metal such as copper is provided. Accordingly, the first bumps 14A are joined to the upper ends of the vias 20 and the second bumps 14B are joined to the lower ends of the vias 20, so that the semiconductor chip 12 and the substrate 13 are electrically connected through the vias 20 (or the interposer 11A).

The interposer 11A may be attached to the semiconductor device 10A by:
(a) joining the semiconductor chip 12 to the interposer 11A by flip-chip bonding through the first bumps 14A and thereafter joining the interposer 11A on which the semiconductor chip 12 is mounted to the substrate 13 by flip-chip bonding through the second bumps 14B; or
(b) joining the interposer 11A to the substrate 13 by flip-chip bonding through the second bumps 14B and thereafter joining the semiconductor chip 12 to the interposer 11A by flip-chip bonding through the first bumps 14A.

Thereafter, underfill resin 21A is provided between the semiconductor chip 12 and the interposer 11A, and underfill resin 21B is provided between the interposer 11A and the substrate 13. As a result, the semiconductor device 10A shown in FIG. 3 is manufactured.

The underfill resin 21A and the underfill resin 21B are formed by, for instance, mixing an inorganic material filler into epoxy resin so as to have thermal conductivity. It is desirable that the coefficient of thermal expansion of the underfill resin 21A be set to a substantially intermediate value between the coefficients of thermal expansion of the semiconductor chip 12 and the interposer 11A. Further, it is desirable that the coefficient of thermal expansion of the underfill resin 21B be set to a substantially intermediate value between the coefficients of thermal expansion of the interposer 11A and the substrate 13.

As described above, according to the semiconductor device 10A of this embodiment, the interposer 11A is provided to oppose the circuit surface 22 of the semiconductor chip 12, and the semiconductor chip 12 is joined to the interposer 11A by flip-chip bonding through the first bumps 14A. Accordingly, heat generated in the semiconductor chip 12 is conducted to the interposer 11A via the first bumps 14A.

Further, the underfill resin 21A is provided between the semiconductor chip 12 and the interposer 11A. As described above, an inorganic material filler is mixed into the underfill resin 21A so that the underfill resin 21A has thermal conductivity. Accordingly, the heat generated in the semiconductor chip 12 is also conducted to the interposer 11A via the underfill resin 21A. Therefore, the heat generated in the semiconductor chip 12 can be dissipated with efficiency.

Further, the interposer 11A, made of ceramic including aluminum nitride as described above, has higher thermal conductivity than the substrate 13. That is, the interposer 11A has a heat dissipating function. Accordingly, the heat generated in the semiconductor chip and conducted via the first bumps 14A and the underfill resin 21A to the interposer 11A is dissipated thereby.

At this point, since the semiconductor chip 12A is joined to the interposer 11A by flip-chip bonding, the circuit surface 22 that particularly generates a large amount of heat in the semiconductor chip 12A opposes the interposer 11A. That is, according to this embodiment, the circuit surface 22 and the interposer 11A can be arranged close to each other so that the heat generated (on the circuit surface 22) in the semiconductor chip 12 can be conducted to and dissipated by the interposer 11A with efficiency. As a result, the semiconductor chip 12 can be cooled with efficiency, and accordingly, can operate with high reliability.

Further, according to the semiconductor device 10A of this embodiment, the area of the interposer 11A achieving the heat dissipating function is greater than the area of the semiconductor chip 12. This increases the heat dissipating area of the interposer 11A, thus increasing the heat dissipation effect. Therefore, the semiconductor chip 12 can be cooled with efficiency, and accordingly, can operate with high reliability.

Further, as described above, the underfill resin 21A is provided between the semiconductor chip 12 and the interposer 11A. Accordingly, although the semiconductor chip 12 and the interposer 11A have different coefficients of thermal expansion, it is possible to prevent stress from concentrating at the joining of the semiconductor chip 12 and the interposer 11A, where the first bumps 14A are joined to the semiconductor chip 12 and the interposer 11A. As a result, the reliability of the semiconductor device 10A can be increased.

Further, according to this embodiment, the coefficient of thermal expansion of the interposer 11A is set to a value (substantially an intermediate value) between the coefficients of thermal expansion of the semiconductor chip 12 and the substrate 13. Accordingly, the difference between the coefficients of thermal expansion of the semiconductor chip 12 and the interposer 11A and the difference between the coefficients of thermal expansion of the substrate 13 and the interposer 11A can be smaller than the difference between the coefficients of thermal expansion of the semiconductor chip 12 and the substrate 13.

Therefore, according to the semiconductor device 10A of this embodiment, stress relaxation occurs in the interposer 11A. Accordingly, a stress generated between the semiconductor chip 12 and the interposer 11A and a stress generated between the substrate 13 and the interposer 11A can be reduced compared with a stress generated between the semiconductor chip 2 (2A and 2B) and the substrate 3 that are directly joined in the conventional structure (FIGS. 1 and 2). As a result, even when the semiconductor device 10A is subjected to heat treatment to be mounted on the motherboard 16, it is possible to prevent incomplete joining due to stress from occurring at the joining positions of the first bumps 14A and of the second bumps 14B. Thus, the reliability of the semiconductor device 10A can be increased.

Further, according to this embodiment, the coefficient of thermal expansion of the underfill resin 21A may be set to a substantially intermediate value between those of the semiconductor chip 12 and the interposer 11A, and the coefficient of thermal expansion of the underfill resin 21B may be set to a substantially intermediate value between those of the interposer 11A and the substrate 13 as described above. This can also prevent incomplete joining due to stress from occurring at the joining positions of the first bumps 14A and of the second bumps 14B, thus increasing the reliability of the semiconductor device 10A.

Next, a description is given, with reference to FIGS. 4 through 10D, of second through sixth embodiments of the present invention.

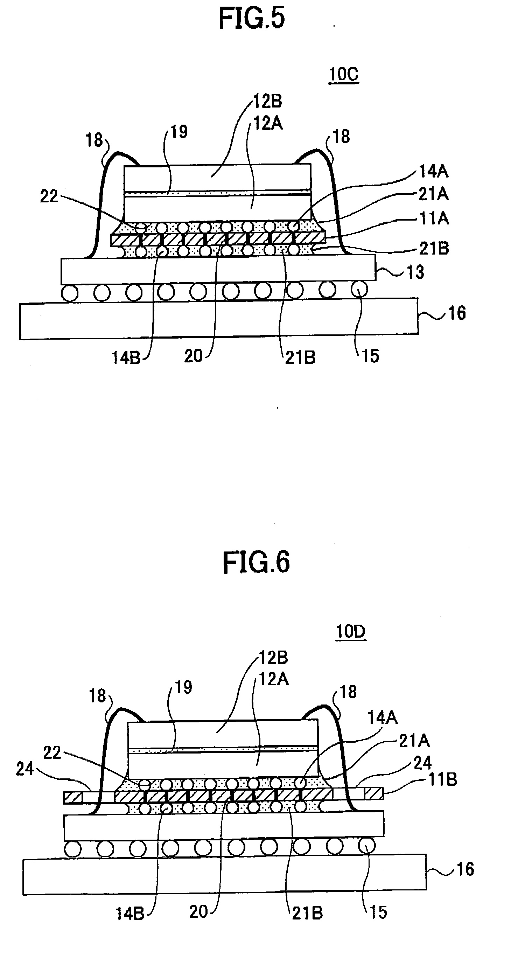

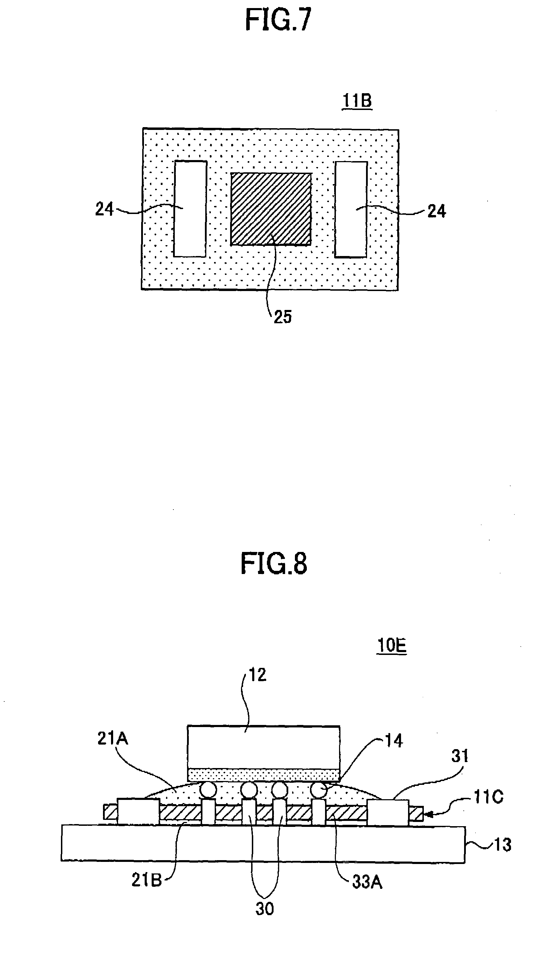

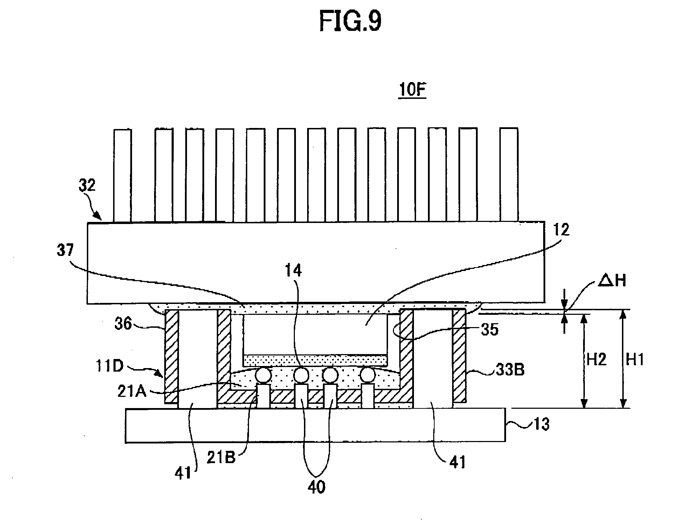

FIG. 4 is a diagram showing a semiconductor device 10B according to the second embodiment. FIG. 5 is a diagram showing a semiconductor device 10C according to the third embodiment. FIG. 6 is a diagram showing a semiconductor device 10D according to the fourth embodiment. FIG. 8 is a diagram showing a semiconductor device 10E according to the fifth embodiment. FIG. 9 is a diagram showing a semiconductor device 10F according to the sixth embodiment. In FIGS. 4 through 10D, the same elements as those of FIG. 3 are referred to by the same numerals, and a description thereof is omitted.

First, a description is given of the second embodiment. The semiconductor device 10B of the second embodiment shown in FIG. 4 is formed by providing a heat dissipating fin 17 (a heat dissipating member) to the semiconductor device 10A of the first embodiment shown in FIG. 3. The heat dissipating fin 17 has a cavity part formed in its lower center, and the cavity part is bonded to the rear surface (on the side opposite to the circuit surface 22) of the semiconductor chip 12 by a thermally conductive adhesive agent 26. The lower surface of the heat dissipating fin 17 except for the cavity part is bonded to the interposer 11A by a thermally conductive adhesive agent 27.

According to this embodiment, the heat dissipating fin 17 is further provided so that heat generated in the semiconductor chip 12 is dissipated by both the interposer 11A and the heat dissipating fin 17. Further, part of the heat conducted from the semiconductor chip 12 (particularly, the circuit surface 22) to the interposer 11A is dissipated through the heat dissipating fin 17. Therefore, according to the semiconductor device 10B of this embodiment, the heat generated in the semiconductor chip 12 can be dissipated with more efficiency.

Next, a description is given of the third embodiment. The semiconductor device 10C of the third embodiment shown in FIG. 5 includes two semiconductor chips 12A and 12B stacked in layers. The semiconductor chips 12A and 12B have their respective rear surfaces fixed to each other by an adhesive agent 19. Accordingly, the semiconductor chip 12A is in a "face-down" state with respect to the substrate 13, and the semiconductor chip 12B is in a "face-up" state with respect to the substrate 13.

Like in the semiconductor device 10A shown in FIG. 3, the semiconductor chip 12A is joined to the interposer 11A by flip-chip bonding using the first bumps 14A, and the interposer 11A is joined to the substrate 13 by flip-chip bonding through the second bumps 14B. The upper semiconductor chip 12B is electrically connected to the substrate 13 using wires 18.

According to the configuration of this embodiment, where the semiconductor chip 12B is placed on the semiconductor chip 12A, it is impossible to provide a heat dissipating fin on the rear surface of the lower semiconductor chip 12A. Therefore, heat dissipation from the rear surface of the semiconductor chip 12A cannot be expected. By providing the interposer 11A, however, it can be ensured that heat is dissipated from the lower semiconductor chip 12A even when the semiconductor chips 12A and 12B are stacked. Accordingly, the heat dissipation of the semiconductor chip 12A can be improved while increasing the density of the semiconductor device 10C.

Next, a description is given of the fourth embodiment. The semiconductor device 10D of the fourth embodiment shown in FIG. 6 is different from the semiconductor device 10C of FIG. 5 in that an interposer 118 of the semiconductor device 10D has an area greater than that of the interposer 11A of the semiconductor device 10C.

If the area of the interposer 11A is simply enlarged in the semiconductor device 10C of FIG. 5, the wires 18 provided around the interposer 11A prevent the interposer 11A from extending outward beyond the loop formation area of the wires 18 (that is, the wires 18 prevent the interposer 11A from having a greater area).

On the other hand, according to the fourth embodiment, as shown enlarged in FIG. 7, openings 24 are formed outside a bump joining area 25 of the interposer 11B so that the wires 18 are insertable into the openings 24. By thus forming the openings 24 into which the wires 18 are inserted in the interposer 11B, the interposer 11B can be extended outward beyond the loop formation area of the wires 18.

Thus, the semiconductor device 10D of this embodiment can have the interposer 11B greater in area than the interposer 11A, so that heat generated in the semiconductor chip 12A can be dissipated with more efficiency.

According to the above-described embodiments, the material of the interposers 11A and 11B is aluminum nitride, but is not limited thereto. A variety of ceramics such as aluminum oxide are also applicable. Further, the material of the interposers 11A and 11B is not limited to ceramics. A variety of materials such as metal and resin are also employable as far as the materials have high thermal conductivity.

Further, in the above-described embodiments, no particular mention is made of the surface configuration of each of the interposers 11A and 11B. The surfaces of each of the interposers 11A and 11B (except for the regions to which the first and second bumps 14A and 14B are joined) may be made uneven so as to increase the heat dissipating area. This configuration makes it possible to further improve the heat dissipating efficiency of each of the interposers 11A and 11B.

Next, a description is given of the fifth embodiment of the present invention. The semiconductor device 10E of the fifth embodiment shown in FIG. 8 has first copper bumps 30 and second copper bumps 31 provided to an interposer 11C.

The interposer 11C of this embodiment employs silicon as a base material 33A. This is because silicon has good workability, and because the difference between the coefficients of thermal expansion of the interposer 11C and the semiconductor chip 12, which is formed of the same material, can be reduced.

The first copper bumps 30 are provided to oppose a plurality of bumps 14 formed on the semiconductor chip 12. The first copper bumps 30 connect the semiconductor chip 12 and the substrate 13 thermally and electrically.

Accordingly, heat generated in the semiconductor chip 12 is conducted to the interposer 11C (the base material 33A) via the first copper bumps 30. Further, part of the heat generated in the semiconductor chip 12 is dissipated directly to the substrate 13 through the first copper bumps 30. As described below, however, the volume of each first copper bump 30 is small so that the heat dissipated directly to the substrate 13 through the first copper bumps 30 is small in quantity.

Further, the semiconductor chip 12 is electrically connected to the substrate 13 via the first copper bumps 30. That is, the semiconductor chip 12 is electrically connected to the substrate 13 via the interposer 11C.

On the other hand, the second copper bumps 31 are not electrically connected to the semiconductor chip 12. The second copper bumps 31 are provided around the first copper bumps 30. Specifically, the second copper bumps 31 are formed peripherally around the formation area of the first copper bumps 30. The formation area of the first copper bumps 30 and the formation area of the second copper bumps 31 are separated.

The formation area of the first copper bumps 30 and the formation area of the second copper bumps 31 are thus separated so that the second copper bumps 31 are provided around the first copper bumps 30. Accordingly, the provision of the second copper bumps 31 does not prevent the first copper bumps 30 from being provided with a narrower pitch. Thus, the adjacent first copper bumps 30 can be provided close to each other, so that the density of the semiconductor device 10E can be increased.

As described above, according to the present invention, the second copper bumps 31 thermally connecting the interposer 11C and the substrate 13 are provided separately from the first copper bumps 30 thermally and electrically connecting the semiconductor chip 12 and the substrate 13. Accordingly, the heat generated in the semiconductor chip 12 and conducted to the interposer 11C can be dissipated through not only the first copper bumps 30 but also the second copper bumps 31.

When the volume of each first copper bump 30 and the volume of each second copper bump 31 are compared, the second copper bump 31 is larger in volume than the first copper bump 30. The first and second copper bumps 30 and 31 are substantially equal in height (vertical size relative to the substrate 13). Accordingly, the second copper bump 31 has a greater cross section than the first copper bump 30. As a result, the second copper bump 31 has lower thermal resistance than the first copper bump 30.

Accordingly, the heat generated in the semiconductor chip 12 and conducted to the interposer 11C is dissipated to the substrate 13 mainly through the second copper bumps 31. Therefore, even if the first copper bumps 30 are formed with high density so as to correspond to the bumps 14 formed on the semiconductor chip 12, the heat generated in the semiconductor chip 12 can be dissipated with efficiency through the second copper bumps 31. This prevents the substrate 13 from warping, and prevents the generation of internal stress due to the difference in thermal expansion between components (such as the semiconductor chip 12, the substrate 13, and the interposer 11C) in the semiconductor device 10E.

Further, the second copper bumps 31 have higher mechanical strength than the first copper bumps 30. Accordingly, even if a stress is generated in the semiconductor device 10E because of the difference in thermal expansion between the components, the stress can be received by the second copper bumps 31. Consequently, even if a stress is generated, the first copper bumps can escape being broken. Accordingly, the electrical reliability of the semiconductor device 10E can be increased.

Next, a description is given of the sixth embodiment. Like the above-described semiconductor device 10B of the second embodiment (FIG. 4), the semiconductor device 10F of the sixth embodiment shown in FIG. 9 includes a heat dissipating fin 32 (a heat dissipating member).

The heat dissipating fin 32 is supported by an interposer 11D, and is thermally connected to the semiconductor chip 12 on its upper surface (on the side opposite to the surface opposing the interposer 11D). Specifically, thermal grease 37 of high thermal conductivity is provided between the upper surface of the semiconductor chip 12 and the lower surface of the heat dissipating fin 32. The semiconductor chip 12 and the heat dissipating fin 32 are thermally connected via the thermal grease 37.

Referring to FIG. 9, the interposer 11D employed in the semiconductor device 10F has a concave part 35 formed in its center. The semiconductor chip 12 is provided in the concave part 35. A support part 36 supporting the heat dissipating fin 32 is formed on the periphery of the concave part 35. First copper bumps 40 are formed to penetrate vertically through the bottom of the concave part 35. Second copper bumps 41 are formed to penetrate vertically through the support part 36.

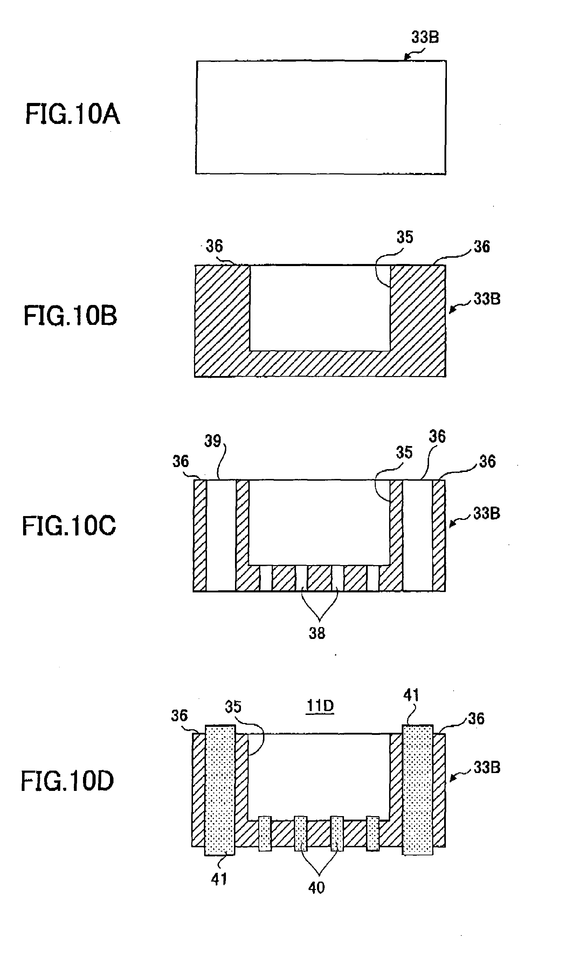

FIGS. 10A through 10D are diagrams showing a method of forming the interposer 11D. First, as shown in FIG. 10A, a rectangular base material 33B is prepared to form the interposer 11D. In this embodiment, silicon is employed as the base material 33B.

Next, as shown in FIG. 10B, etching is performed on the base material 33B so that the concave part 35 is formed. The formation of the concave part 35 simultaneously causes the support part 36 to be formed around the concave part 35. The etching performed in this process may desirably be anisotropic etching in terms of a higher aspect ratio. However, other etching methods are also employable.

After the concave part 35 is formed as described above, first through holes 38 and second through holes 39 are formed as shown in FIG. 10C. The first through holes 38 are formed to penetrate through the bottom of the concave part 35, and the second through holes 39 are formed to penetrate through the support part 36.

Next, as shown in FIG. 10D, copper plating is performed on the first and second through holes 38 and 39 formed as described above, so that the first and second copper bumps 40 and 41 are formed. The interposer 11D is formed by performing the above-described series of processes.

According to the interposer 11D of the above-described configuration, the semiconductor chip 12 is provided in the concave part 35, and the bumps 14 provided to the semiconductor chip 12 are joined to the first copper bumps 40. The underfill resin 21A is also provided. The lower ends of the first and second copper bumps 40 and 41 are joined to the substrate 13. As a result, the interposer 11D is connected to the substrate 13 thermally and electrically.

The heat dissipating fin 32 is placed on the interposer 11D provided on the substrate 13 with the thermal grease 37 being applied on the interposer 11D. As a result, the upper surface of the semiconductor chip 12 and the heat dissipating fin 32 are thermally connected via the thermal grease 37, and the upper end of each second copper bump 41 and the heat dissipating fin 32 are thermally connected via the thermal grease 37.

Accordingly, heat generated in the semiconductor chip 12 is dissipated by both the interposer 11D and the heat dissipating fin 32. Further, part of the heat conducted from the semiconductor chip 12 to the interposer 11D is dissipated through the heat dissipating fin 32. Accordingly, the heat generated in the semiconductor chip 12 can be dissipated with more efficiency.

Here, letting the vertical distance between the upper surface of the substrate 13 and the position at which the interposer 11D (the support part 36) supports the heat dissipating fin 32 be H1, and letting the vertical distance between the upper surface of the substrate 13 and the upper surface of the semiconductor chip 12 (opposing the heat dissipating fin 32) be H2, H1 is set to be greater than H2 (H1 > H2). According to this embodiment, this difference in vertical distance ΔH (= H1 - H2) is set to be in the range of 5 to 50 µm.

According to this configuration, the heat dissipating fin 32 having a heavy weight is supported by the interposer 11D so as to prevent the weight of the heat dissipating fin 32 from being applied to the semiconductor chip 12. This can prevent stress from being generated in the semiconductor chip 12 itself and at the joining of the semiconductor chip 12 and the interposer 11D (the joining parts of the bumps 14). Accordingly, it is possible to prevent the semiconductor chip 12 and the above-described joining from being damaged. Therefore, the reliability of the semiconductor device 10F can be increased.

According to this embodiment, the heat dissipating fin 32 is supported by the interposer 11D. The heat dissipating fin 32, however, is supported by the support part 36 of the interposer 11D, and the semiconductor chip 12 is provided inside the concave part 35 formed in the interposer 11D. Accordingly, the semiconductor device 10F can be made compact.

The present invention is not limited to the specifically disclosed embodiments, and variations and modifications may be made without departing from the scope of the present invention.

The present application is based on Japanese priority patent applications No. 2003-060302, filed on March 6, 2003, and No. 2003-195946, filed on July 11, 2003, the entire contents of which are hereby incorporated by reference.

## Claims

1. A semiconductor device, comprising:
a semiconductor chip;
a substrate to which the semiconductor chip is connected; and
an interposer provided between the semiconductor chip and the substrate so as to oppose a surface of the semiconductor chip on which a circuit is formed, the interposer connecting the semiconductor chip and the substrate electrically, the interposer being thermally connected to the semiconductor chip.

2. The semiconductor device as claimed in claim 1, wherein the semiconductor chip is joined to the interposer by flip-chip bonding.

3. The semiconductor device as claimed in claim 1, wherein the interposer has an area greater than an area of the semiconductor chip.

4. The semiconductor device as claimed in claim 1, further comprising thermally conductive resin provided between the semiconductor chip and the interposer.

5. The semiconductor device as claimed in claim 1, wherein the interposer has a coefficient of thermal expansion set to a value between a coefficient of thermal expansion of the semiconductor chip and a coefficient of thermal expansion of the substrate.

6. The semiconductor device as claimed in claim 1, wherein the interposer comprises:
first bumps connecting the semiconductor chip and the substrate thermally and electrically; and
second bumps provided around the first bumps, the second bumps connecting the interposer and the substrate thermally.

7. The semiconductor device as claimed in claim 6, wherein the second bumps are larger in volume than the first bumps.

8. The semiconductor device as claimed in claim 1, further comprising a heat dissipating member supported by the interposer, the heat dissipating member being thermally connected to the semiconductor chip on a surface thereof on a side opposite to the surface of the semiconductor chip opposing the interposer.

9. The semiconductor device as claimed in claim 8, wherein a distance between the substrate and a position at which the interposer supports the heat dissipating member is larger than a distance between the substrate and the surface of the semiconductor chip opposing the heat dissipating member.

10. The semiconductor device as claimed in claim 9, wherein the interposer comprises:
a concave part in which the semiconductor chip is provided; and
a support part supporting the heat dissipating member.
